# EUROPEAN PATENT APPLICATION

(11) **EP 4 746 669 A1**
(43) Date of publication of application: **20.05.2026**
(21) Application number: 25198271.6
(22) Date of filing: 26.08.2025
(51) Int. Cl.: H10P 54/00

(54) **WAFER LEVEL MULTI FORM FACTOR DIE SINGULATION**

(30) Priority: 27.09.2024 US 202418900595
(71) Applicant: Intel Corporation, Santa Clara, CA 95054 (US)
(72) Inventor: BAKER, Michael J., Gilbert, 85297 (US); JAYARAM, Vidya, Chandler, 85249 (US); LOPEZ, Albert S., Tempe, 85283 (US); MYERS, Preston T., Chandler, 85249 (US); JAYARAMAN, Saikumar, Chandler, 85248 (US)
(74) Representative: HGF

(57) **Abstract**

Systems, components, and methods for wafer level semiconductor die singulation are provided. Die singulation of differently sized semiconductor dies can be accomplished without sacrificing certain semiconductor dies in favor of others.

## Description

### FIELD

Descriptions are generally related to semiconductor device manufacturing, and more particular descriptions are related to wafer level semiconductor die singulation.

### BACKGROUND

Semiconductor chips are central to intelligent devices and systems, such as personal computers, laptops, tablets, phones, servers, and other consumer and industrial products and systems. Manufacturing semiconductor chips presents a number of challenges and these challenges are amplified as devices become smaller and performance demands increase. Challenges include, for example, unwanted material interactions, precision and scaling requirements, power delivery requirements, limited failure tolerance, and material and manufacturing costs.

Semiconductor chips can be manufactured on a wafer that is then cut apart to create individual semiconductor devices. Generally, mechanical wafer singulation is done on wafers having uniformly sized dies, i.e., all the semiconductor devices on the wafer are the same size. Mechanical singulation of wafers that have multiple die sizes can require sacrifice of all other die sizes in order to singulate a single semiconductor die size. Before a semiconductor device is sold to consumers, extensive manufacturing and operational testing is performed. As part of the manufacturing testing process, wafers are manufactured having different sized dies ("shuttles"). These shuttles can expedite design testing results but the need to sacrifice all but one size of semiconductor die increases process time, and results in low wafer usage and increased testing costs.

### BRIEF DESCRIPTION OF THE DRAWINGS

The figures are provided to aid in understanding the disclosure. The figures can include diagrams and illustrations of examples of structures, assemblies, data, methods, and systems. For ease of explanation and understanding, these structures, assemblies, data, methods, and systems, the figures are not an exhaustively detailed description. The figures therefore should not be understood to depict the entire metes and bounds of structures, assemblies, data, methods, and systems possible without departing from the scope of the disclosure. Additionally, features are not necessarily illustrated relatively to scale due in part to the small sizes of some features and the desire for clarity of explanation in the figures.
**Figures 1A - 1B** show examples of reticles and wafers comprising semiconductor chips.
**Figures 2** illustrates a method for singulating a wafer containing semiconductor chips.
**Figures 3A - 3C** provide temporary carriers for semiconductor wafers.
**Figures 4A - 4E** provide additional temporary carriers for semiconductor wafers.
**Figure 5** shows a system capable of singulating a wafer containing semiconductor chips.
**Figure 6** provides a method for singulating a wafer containing semiconductor chips.
**Figure 7** provides an example of a computing system.

Descriptions of certain details and implementations follow, including non-limiting descriptions of the figures, which depict some examples and implementations.

### DETAILED DESCRIPTION

References to one or more examples are to be understood as describing a particular feature, structure, or characteristic included in at least one implementation. The phrases "one example" or "an example" are not necessarily all referring to the same example or embodiment. Any aspect described herein can potentially be combined with any other aspect or similar aspect described herein, regardless of whether the aspects are described with respect to the same figure or element.

The words "connected" and/or "coupled" can indicate that two or more elements are in direct physical or electrical contact with each other. The term "coupled," however, can also mean that two or more elements are not in direct contact with each other and are instead separated by one or more elements but they may still co-operate or interact with each other, for example, physically, magnetically, optically, or electrically.

The words "first," "second," and the like, do not indicate order, quantity, or importance, but rather are used to distinguish one element from another. The words "a" and "an" herein do not indicate a limitation of quantity, but rather denote the presence of at least one of the referenced items. The terms "follow" or "after" can indicate immediately following or following some other event or events. Other sequences of operations can also be performed according to alternative embodiments. Furthermore, additional operations may be added or removed depending on the application.

Disjunctive language such as the phrase "at least one of X, Y, or Z," is used in general to indicate that an element or feature, may be either X, Y, or Z, or any combination thereof (e.g., X, Y, and/or Z). Thus, this disjunctive language should be understood not to imply that certain embodiments require at least one of X, at least one of Y, or at least one of Z to each be present.

Flow diagrams as illustrated herein provide examples of sequences of various process actions. The flow diagrams can indicate operations to be executed by a software or firmware routine, as well as by physical operations. Physical operations can be performed by semiconductor processing and/or testing equipment, including computer systems that run testing protocols and operate aspects of testing equipment and systems. Although shown in a particular sequence or order, unless otherwise specified, the order of the actions can be modified. Thus, the illustrated diagrams should be understood as examples. The processes can be performed in a different order, and some actions can be performed in parallel. Additionally, one or more actions can be omitted and not all implementations may necessarily perform all actions.

Various components described can be a means for performing the operations or functions described. Components described can include software, hardware, or a combination of these. Some components can be implemented as software modules, hardware modules, special-purpose hardware (for example, application specific hardware, application specific integrated circuits (ASICs), and digital signal processors (DSPs)), embedded controllers, and/or hardwired circuitry. Other components can be semiconductor processing and/or testing equipment that is able to perform physical operations such as, for example, lithography, probing, material deposition (for example, chemical vapor deposition, atomic layer deposition, physical vapor deposition, electrodeposition, and/or sputtering), chemical mechanical polishing, plasma beam etching, and etching.

To the extent various computer operations or functions are described herein, they can be described or defined as software code, instructions, configuration, and/or data. The software content can be provided via an article of manufacture with the content stored thereon, or via a method of operating a communication interface to send data via the communication interface. A machine-readable storage medium can cause a machine to perform the functions or operations described. A machine-readable storage medium includes any mechanism that stores information in a tangible form accessible by a machine (e.g., computing device), such as recordable/non-recordable media (e.g., read only memory (ROM), random access memory (RAM), magnetic disk storage media, optical storage media, flash memory devices). Instructions can be stored on the machine-readable storage medium in a non-transitory form. A communication interface includes any mechanism that interfaces to, for example, a hardwired, wireless, or optical medium to communicate to another device, such as, for example, a memory bus interface, a processor bus interface, an Internet connection, a disk controller.

Terms such as chip, die, IC (integrated circuit) chip, IC die, microelectronic chip, microelectronic die, semiconductor die, semiconductor device, and/or semiconductor chip are interchangeable and refer to a device comprising integrated circuits that can be formed in part from semiconductor materials.

Semiconductor chip manufacturing processes are sometimes divided into front end of the line (FEOL) processes and back end of the line (BEOL) processes. Electronic circuits and active and passive devices within the chip, such as for example, transistors, capacitors, resistors, and/or memory cells, are manufactured in what can be referred to as FEOL processes. Memory cells include, for example, electronic circuits for random access memory (RAM), such as static RAM (sRAM), dynamic RAM (DRAM), read only memory (ROM), non-volatile memory, and/or flash memory. FEOL processes can be, for example, complementary metal-oxide semiconductor (CMOS) processes. BEOL processes include metallization of the chip where interconnects are formed in layers and the feature size of the interconnect increases in layers nearer the surface of the semiconductor chip. Interconnects in, for example, semiconductor chips that are integrated into heterogeneous packages (such as, for example, packages that include memory and logic chips), can also include through silicon vias (TSVs) that transverse the semiconductor chip device region. Semiconductor devices that have TSVs can blur distinctions between BEOL and FEOL processes.

Semiconductor chip interconnects can be created by forming a trench or though-layer via by etching a trench or via structure into a dielectric layer and filling the trench or via with metal. Dielectric layers can comprise, for example, low-κ dielectrics, SiO₂, silicon nitride (SiN), silicon carbide (SiC), and/or silicon carbonitride (SiCN). Low-κ dielectrics include for example, fluorine-doped SiO₂, carbon-doped SiO₂, porous SiO₂, porous carbon-doped SiO₂, combinations for the foregoing, and also these materials with gas-filled gaps or bubbles. Dielectric layers that include conducting features can be interlayer dielectric (ILD) features. In general, low-κ dielectrics exhibit a dielectric constant that is less than that of SiO₂.

The terms "package," "packaging," "IC package," or "chip package," "microelectronics package," or "semiconductor chip package" are interchangeable and generally refer to an enclosed carrier of one or more chips, in which the chips are coupled to a package substrate and encapsulated. The package substrate provides electrical interconnections between the chip(s) and other chips and/or a motherboard or other circuit board for I/O (input/output) communication and power delivery. A package with multiple chips can, for example, be a system in a package.

A package substrate generally includes dielectric layers or structures having conductive structures on, through, and/or embedded in the dielectric layers. The dielectric layers can be, for example, build-up layers. Dielectric materials include Ajinomoto build-up film (ABF), although other dielectric materials are possible. Semiconductor package substrates can have cores or be coreless. Semiconductor packages having cores can have dielectric layers such as buildup layers on more than one side of a core, such as on two opposite sides of a core. Cores can include through-core vias that contain a conductive material. Other structures or devices are also possible within a package substrate.

A "core" or "package core" generally refers to a layer usually embedded within a package substrate. The core can provide structure or stiffness to a package substrate. A core is an optional feature of a package substrate. The core can be a dielectric organic or inorganic material and may have conductive vias extending through the layer. The conductive vias can include a metal, for example, copper. A package core can, for example, be comprised of a glass material (such as, for example, aluminosilicate, borosilicate, alumino-borosilicate, silica, and fused silica), silicon, silicon nitride, silicon carbide, gallium nitride, or aluminum oxide. In some examples, core materials are glass-fiber reinforced organic resins such as epoxy-based resins. A further example package substrate core is FR4 (woven glass fiber reinforces epoxy). In other examples, package substrate cores are solid amorphous glass layers.

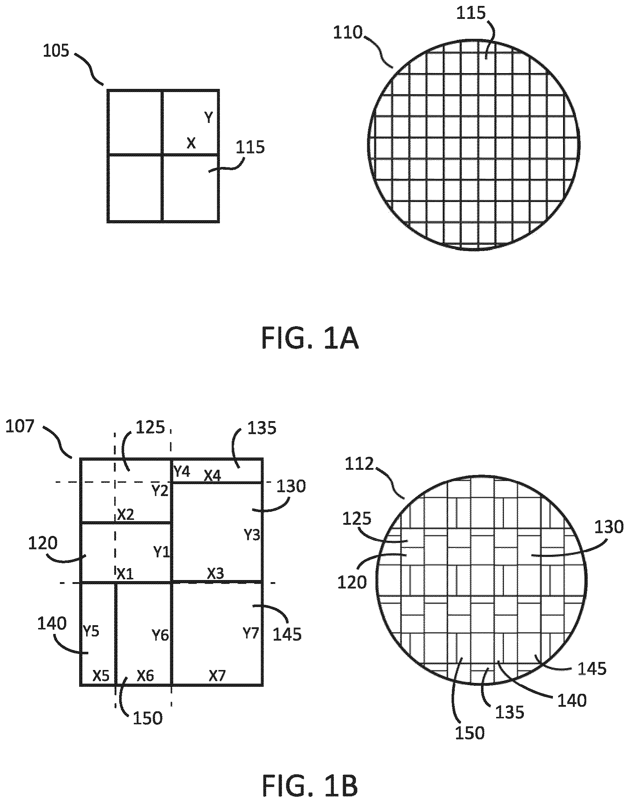

Figures 1A - 1B show representations of a "full reticle" 105 and 107 and a "full wafer" 110 and 112. In Figure 1A, the full reticle 105 comprises four similarly sized semiconductor dies 115, having sides X and Y on a face of the semiconductor die. In Figure 1B, the full reticle 107 comprises seven differently-sized semiconductor dies 120, 125, 130, 135, 140, 145, 150. The differently-sized semiconductor dies 120, 125, 130, 135, 140, 145, 150 have sides X1-X7 and Y1-Y7 where some or all of the sides on a face of the semiconductor die are differently sized for each semiconductor die 120, 125, 130, 135, 140, 145, 150. Standard mechanical singulation tools can singulate the wafer 110 without sacrificing semiconductor dies. In contrast, standard mechanical singulation tools are typically not able to singulate wafer 112 without sacrificing semiconductor dies having certain shapes. Dashed lines illustrate how the wafer might be cut in order to singulate dies and it can be seen the semiconductor die 120 and 125 would be sacrificed in this cutting scheme.

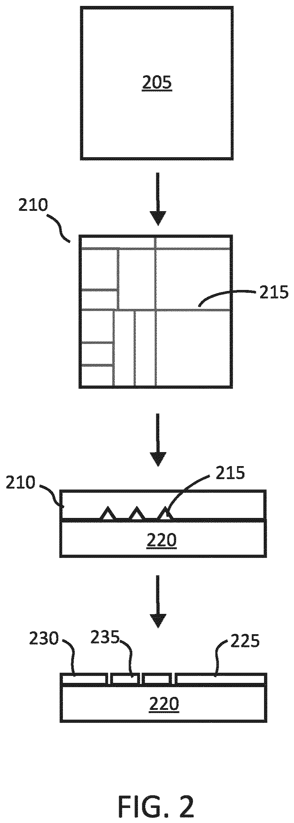

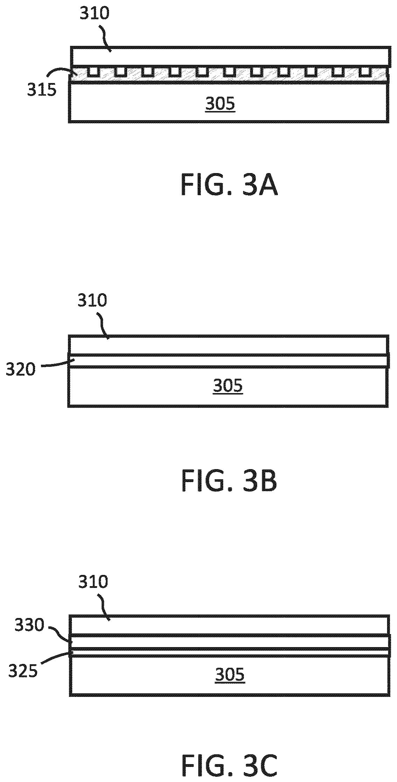

Figure 2 illustrates a process for singulation of wafers to create individual semiconductor dies. A process of Figure 2 can be used to singulate wafers that contain semiconductor dies of different sizes without having to sacrifice semiconductor dies. Structure 205 shows an exemplary wafer section (portion) in which different sized semiconductor dies are housed. A plasma trenching (etching) process can be performed to create trenches 215 that define edges of semiconductor devices (e.g., 230, 235, and 225) on a first side of the wafer. (Other types and numbers of semiconductor dies are possible.) The wafer can be flipped and attached to a carrier 220 so that a second side of the wafer is exposed for thinning of the second side of the wafer. Some examples of carriers 220 are shown in Figures 3 - 4. Thinning can be done using, for example, a mechanical grinding process, chemical mechanical grinding process, or an etching process. Thinning of the second side of the wafer creates individual semiconductor chips 230, 235, and 225. (Not all the semiconductor chips that are created are pictured.) Depending on the type of carrier 220 chosen and manufacturing preference, semiconductor chips 230, 235, and 225 (etc.) can be stored on the carrier or picked off the carrier, with, for example a robotic pick and place system.

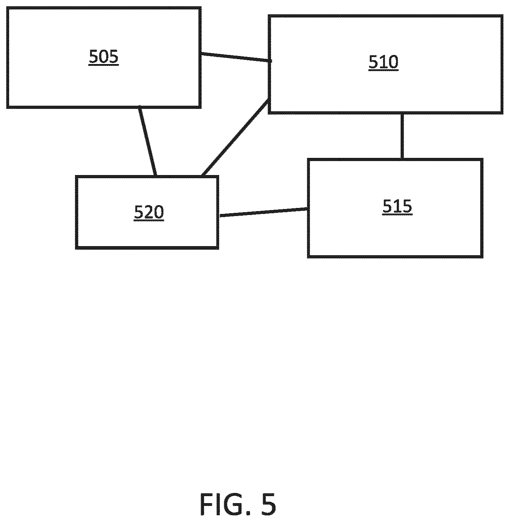

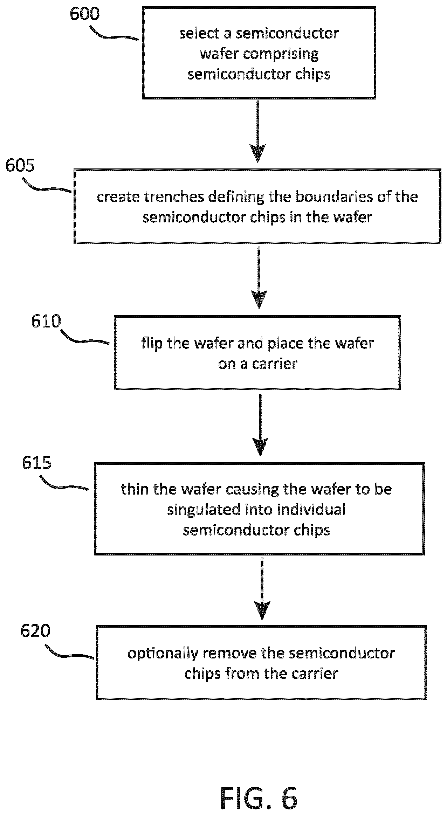

Figures 3A -3C show examples of temporary carriers for wafers that are useful in the method shown in and described with respect to Figures 2 and 6 and the system shown in and described with respect to Figure 5. The carriers of Figures 3A -3C can be, for example, the carrier 220 of Figure 2. Figure 3A shows a carrier that comprises a carrier base 305 and a dry texture adhesive layer 315. The dry texture adhesive layer 315 can have a surface that is flat or patterned. A patterned surface is shown in Figure 3A. The pattern can be one that has a topography that causes the wafer 310 to be thinned to be held to the surface of the carrier. A large number of topography patterns are possible, such as, for example, cylinders with modified tips that contact the wafer (and semiconductor dies). Cylinders can have varying aspect ratios and thickness at the top from the bottom (where they are attached to the base film). Tips can be rounded, flat, pointed, or have a more complex shape, such as a suction cup. After a wafer 310 thinning process, the semiconductor dies can be released with a mechanical process, such as mechanical buckling. A dry texture adhesive layer 315 can comprise an organic polymer and/or an epoxy. The wafer 310 to be thinned can be, for example, the wafer 210 of Figure 2. Figure 3B provides a carrier that comprises a carrier base 305 and thermal release adhesive layer 320. After a wafer 310 thinning process, the semiconductor dies can be released using, for example, using heat, such as a thermal shock process. In Figures 3A and 3B, the carrier base 305 can be comprised, for example, of silicon or glass. In Figure 3C, a carrier comprises a carrier base 305, an ultraviolet light (UV) release layer 325, and an adhesive layer 330. After a wafer 310 thinning process, the semiconductor dies can be released using, UV light. The adhesive can be cleaned from the semiconductor dies, for example, using a solvent. In Figure 3C the carrier base 305 can be comprised of a UV-permeable glass.

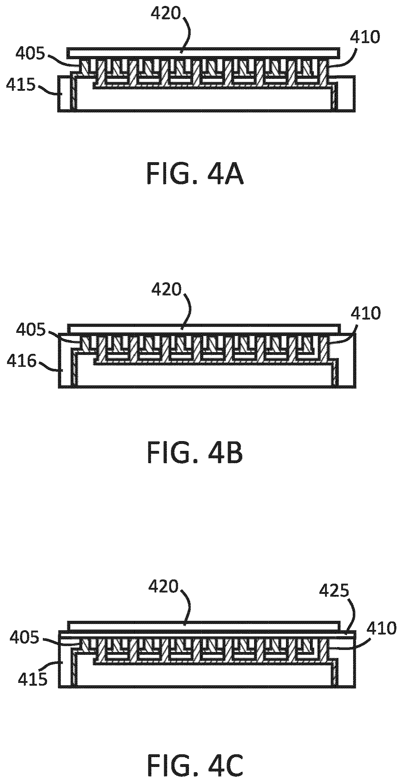

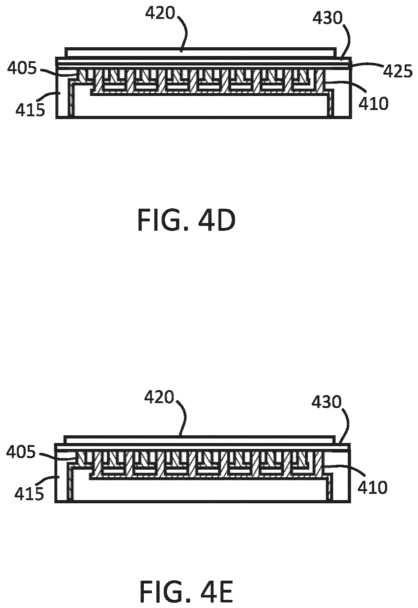

Figures 4A - 4E provide additional temporary carriers for wafers that are useful in the method shown in and described with respect to Figures 2 and 6 and the system shown in and described with respect to Figure 5. The carriers of Figures 4A - 4E can be, for example, the carrier 220 of Figure 2. Figures 4A - 4E show electrostatic carriers and hybrid electrostatic carriers. In Figure 4A, an electrostatic carrier comprises electrode layers 405 and 410 on a silicon wafer 415. A wafer 420 to be thinned and/or singulated (singulated, such as by backside thinning), is held against the electrode surfaces by electrostatic forces. The wafer 420 to be thinned and/or singulated is, for example, the wafer 210 of Figure 2. In Figure 4B, the electrode layers 405 and 410 are embedded in a silicon wafer 416, whereas in Figure 4A, electrode layers 405 and 410 are on a silicon wafer 415. Alternatively, the electrode layers 405 and 410 can be embedded in other materials, such as, for example, polymers, glass, ceramics, silicon dioxide, and/or fiberglass. In Figure 4C, the carrier of Figure 4B also includes a dielectric layer 425 between electrode layers 405 and 410 and the wafer 420 to be thinned and/or singulated. The dielectric layer 425 can be a uniform dielectric layer and can comprise, for example, one or more layers, comprised of for example, organic polymers, such for example, a polyamide. A layer of polyamide can be very thin (e.g., in the range of 1-10 µm thick). In Figure 4D, the carrier of Figure 4C also includes a dry texture adhesive layer 430. The dry texture adhesive layer 430 can provide increased surface area for contact with the wafer 420 and can reduce lateral movement of the wafer 420 during handling. The dry texture adhesive layer 430 can comprise one or more layers, comprised of for example, organic polymers. In Figure 4E, the carrier of Figure 4D does not include the dielectric layer 425.

Figure 5 illustrates a system for singulating a wafer comprising semiconductor chips. The system of Figure 5 can be used to singulate wafers comprising semiconductor chips of different sizes (without the need to sacrifice some of the semiconductor chips) and/or semiconductor devices comprising optical components. The wafer singulation system comprises a plasma etcher 505, a wafer handling unit 510, a wafer thinning unit 515, and a computer system 520. The plasma etcher 505 can include components that can create a plasma beam that can be directed by instructions from a computing system to cause trenches to be etched into a surface of a semiconductor wafer to define the borders of semiconductor chips housed on the wafer. The trenches can be, for example, trenches 215. The semiconductor chips can be ones that are different sizes. The wafer handling unit 510 can include mechanical systems for flipping a wafer and loading it onto a carrier. The wafer handling unit 510 can include a pick and place system, for example. The carrier can be, for example, one of the carriers of Figures 3A - 3C or 4A -4E. The wafer thinning unit 515 can be, for example a chemical mechanical polishing system. The computing system 510 can comprise one or more components, including memory and/or storage device(s) for storing instructions. Instructions can be stored on the computing system 510 for performing the method of Figures 2 and 6, for example. A storage device can be a computer readable medium for storing instructions. Semiconductor devices that have been singulated from the wafer can be removed from a carrier and stored, by, for example, a pick and place unit. Dies can be stored, for example, in a wafer level cassette front opening unified pod (FOUP)

Figure 6 provides a method for singulating a wafer comprising semiconductor chips. The method of Figure 6 can allow a wafer comprising semiconductor chips of different sizes to be singulated without having to sacrifice some of the semiconductor chips. A wafer comprising semiconductor chips is selected 600 for singulation. Trenches that define the edges of the semiconductor chips are created in a first surface of the wafer 605. Trenches can be created with a plasma beam system, for example. The wafer can be flipped and placed on a carrier 610. The carrier can be, for example, one of the carriers of Figures 3A - 3C or 4A -4E. The second side of the wafer is thinned causing the wafer to be singulated into individual chips 615. The wafer can be thinned using, for example, a chemical mechanical polish. The semiconductor chips can optionally be removed from the carrier 620. Instructions for performing the method of Figure 6 can be stored on a computer readable medium.

Methods described herein can produce semiconductor chips having smooth edges, so that an edge has no features (variations from a straight line or side) that are larger than 30 µm. Features can be the result of chipping or cracking during singulation, especially mechanical singulation processes. A semiconductor chip can have smooth sides (edges) where it has been singulated that do not have chips or cracks that are larger than 30 µm in any dimension - or the largest dimension of the chip or crack is smaller than 30 µm.

Semiconductor device wafers (i.e., 110, 112, 210, 310, and 420) can include, for example, a silicon or silicon-on-insulator substate. Other materials for semiconductor wafer substrates include, gallium arsenide, germanium, indium antimonide, lead telluride, indium phosphide, indium antimonide, indium gallium arsenide, or gallium antimonide. Other types of wafer substrates are also possible and the devices described herein are not limited to a particular type of substrate.

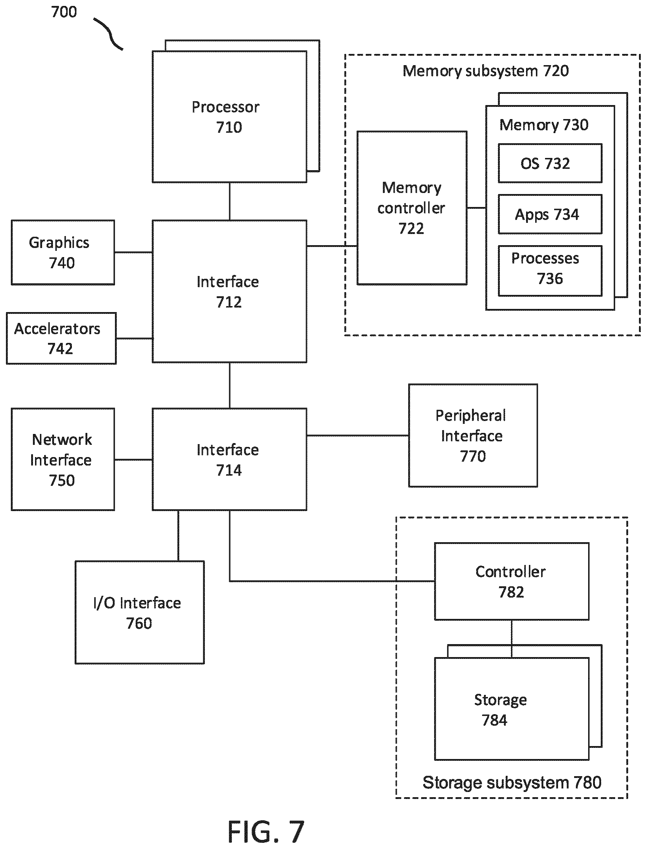

Semiconductor devices (or chips) that can be created, can include, for example, any one of or combination of microprocessors, CPUs (central processing units), GPUs (graphics processing units), processing cores, system on a chips, other processing hardware, a combination of processors or processing cores, programmable general-purpose or special-purpose microprocessors, accelerators, DSPs, I/O management, programmable controllers, ASICs, programmable logic devices (PLDs), devices comprising optical components, HBM, and/or other memory devices. The semiconductor chips can be any of the chips, for example, described herein with respect to Figure 7.

Figure 7 depicts an example computing system. The computing system can be a system used for running equipment in a semiconductor fabrication plant, such as the system of Figure 5. For example, instructions for performing one or more aspects of the process described in Figure 2 and/or 6 can be stored and/or run on the computing system. A computing system 700 can include more, different, or fewer features than the ones described with respect to Figure 7.

Computing system 700 includes processor 710, which provides processing, operation management, and execution of instructions for system 700. Processor 710 can include any type of microprocessor, CPU (central processing unit), GPU (graphics processing unit), processing core, or other processing hardware to provide processing for system 700, or a combination of processors or processing cores. Processor 710 controls the overall operation of system 700, and can be or include, one or more programmable general-purpose or special-purpose microprocessors, DSPs, programmable controllers, ASICs, programmable logic devices (PLDs), or the like, or a combination of such devices.

In one example, system 700 includes interface 712 coupled to processor 710, which can represent a higher speed interface or a high throughput interface for system components needing higher bandwidth connections, such as memory subsystem 720 or graphics interface components 740, and/or accelerators 742. Interface 712 represents an interface circuit, which can be a standalone component or integrated onto a processor die. Where present, graphics interface 740 interfaces to graphics components for providing a visual display to a user of system 700. In one example, the display can include a touchscreen display.

Accelerators 742 can be a fixed function or programmable offload engine that can be accessed or used by a processor 710. For example, an accelerator among accelerators 742 can provide data compression (DC) capability, cryptography services such as public key encryption (PKE), cipher, hash/authentication capabilities, decryption, or other capabilities or services. In some cases, accelerators 742 can be integrated into a CPU socket (e.g., a connector to a motherboard (or circuit board, printed circuit board, mainboard, system board, or logic board) that includes a CPU and provides an electrical interface with the CPU). For example, accelerators 742 can include a single or multi-core processor, graphics processing unit, logical execution unit single or multi-level cache, functional units usable to independently execute programs or threads, application specific integrated circuits (ASICs), neural network processors (NNPs), programmable control logic, and programmable processing elements such as field programmable gate arrays (FPGAs) or programmable logic devices (PLDs). Accelerators 742 can provide multiple neural networks, CPUs, processor cores, general purpose graphics processing units, or graphics processing units can be made available for use by artificial intelligence (AI) or machine learning (ML) models.

Memory subsystem 720 represents the main memory of system 700 and provides storage for code to be executed by processor 710, or data values to be used in executing a routine. Memory subsystem 720 can include one or more memory devices 730 such as read-only memory (ROM), flash memory, one or more varieties of random access memory (RAM) such as static RAM (SRAM), dynamic RAM (DRAM), synchronous DRAM (SDRAM) and/or or other memory devices, or a combination of such devices. Memory 730 stores and hosts, among other things, operating system (OS) 732 that provides a software platform for execution of instructions in system 700, and stores and hosts applications 734 and processes 736. In one example, memory subsystem 720 includes memory controller 722, which is a memory controller to generate and issue commands to memory 730. The memory controller 722 can be a physical part of processor 710 or a physical part of interface 712. For example, memory controller 722 can be an integrated memory controller, integrated onto a circuit within processor 710.

System 700 can also optionally include one or more buses or bus systems between devices, such memory buses, graphics buses, and/or interface buses. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a peripheral component interface (PCI) or PCI express (PCIe) bus, a Hyper Transport or industry standard architecture (ISA) bus, a small computer system interface (SCSI) bus, a universal serial bus (USB), or a Firewire bus.

In one example, system 700 includes interface 714, which can be coupled to interface 712. In one example, interface 714 represents an interface circuit, which can include standalone components and integrated circuitry. In one example, user interface components or peripheral components, or both, couple to interface 714. Network interface 750 provides system 700 the ability to communicate with remote devices (e.g., servers or other computing devices) over one or more networks. Network interface 750 can include an Ethernet adapter, wireless interconnection components, cellular network interconnection components, USB, or other wired or wireless standards-based or proprietary interfaces. Network interface 750 can transmit data to a device that is in the same data center or rack or a remote device, which can include sending data stored in memory.

Some examples of network interface 750 are part of an infrastructure processing unit (IPU) or data processing unit (DPU), or used by an IPU or DPU. An xPU can refer at least to an IPU, DPU, GPU, GPGPU (general purpose computing on graphics processing units), or other processing units (e.g., accelerator devices). An IPU or DPU can include a network interface with one or more programmable pipelines or fixed function processors to perform offload of operations that can have been performed by a CPU. The IPU or DPU can include one or more memory devices.

In one example, system 700 includes one or more input/output (I/O) interface(s) 760. I/O interface 760 can include one or more interface components through which a user interacts with system 700 (e.g., audio, alphanumeric, tactile/touch, or other interfacing). Peripheral interface 770 can include additional types of hardware interfaces, such as, for example, interfaces to semiconductor fabrication equipment and/or electrostatic charge management devices.

In one example, system 700 includes storage subsystem 780. Storage subsystem 780 includes storage device(s) 784, which can be or include any conventional medium for storing data in a nonvolatile manner, such as one or more magnetic, solid state, and/or optical based disks. Storage 784 can be generically considered to be a "memory," although memory 730 is typically the executing or operating memory to provide instructions to processor 710. Whereas storage 784 is nonvolatile, memory 730 can include volatile memory (e.g., the value or state of the data is indeterminate if power is interrupted to system 700). In one example, storage subsystem 780 includes controller 782 to interface with storage 784. In one example controller 782 is a physical part of interface 712 or processor 710 or can include circuits or logic in both processor 710 and interface 714.

A power source (not depicted) provides power to the components of system 700. More specifically, power source typically interfaces to one or multiple power supplies in system 700 to provide power to the components of system 700.

Examples of systems may be implemented in various types of computing, smart phones, tablets, personal computers, and networking equipment, such as switches, routers, racks, and blade servers such as those employed in a data center and/or server farm environment.

### EXAMPLES

A system can comprise: a plasma beam system that is capable of creating trenches in a side of a wafer wherein the trenches define boarders of semiconductor chips housed in the wafer; a wafer handling unit that is capable of flipping a wafer and placing it on a carrier; a wafer thinning unit that is capable of thinning a side of a wafer; and a computing system wherein the computing system comprises instructions for creating trenches in a first side of a wafer wherein the trenches define boarders of semiconductor chips housed in the wafer, flipping a wafer and placing it on a carrier, and for thinning a second side of the wafer. The wafer thinning unit can be a chemical mechanical polishing unit or an etching unit. The computing system can comprise a memory or storage device on which the instructions are stored. The system can also include carrier onto which the wafer can be placed and wherein the carrier can comprise a dry texture adhesive layer, a thermal release adhesive layer, or an ultraviolet light release layer. The system can also include a carrier onto which the wafer can be placed wherein the carrier comprises electrode layers. The system can also include a carrier onto which the wafer can be placed and wherein the carrier comprises electrode layers and a dry texture adhesive. The plasma beam system can be capable of creating trenches that define borders around semiconductor chips of different sizes that are housed in the wafer.

A method can comprise: creating trenches in a first side of a wafer wherein the trenches define boarders of semiconductor chips housed in the wafer; flipping the wafer and placing it on a carrier; and thinning a second side of the wafer wherein thinning the second side of the wafer causes the wafer to be singulated into semiconductor chips. A first set of the semiconductor chips housed in the wafer can have different sizes from a second set of the semiconductor chips housed in the wafer. Thinning the second side of the wafer can be accomplished using chemical mechanical polishing. The carrier can comprise a dry texture adhesive layer, a thermal release layer, or an ultraviolet light release layer. The carrier can comprise electrode layers. The carrier can comprise electrode layers and a dry texture adhesive. The method can also include removing the semiconductor chips from the carrier.

A computer-readable medium on which instructions are stored in a non-transitory form, that when executed by a computer, can cause a system to perform a method of: creating trenches in a first side of a wafer wherein the trenches define boarders of semiconductor chips housed in the wafer; flipping the wafer and placing it on a carrier; and thinning a second side of the wafer wherein thinning the second side of the wafer causes the wafer to be singulated into semiconductor chips. A first set of the semiconductor chips housed in the wafer can have different sizes from a second set of the semiconductor chips housed in the wafer. The carrier can comprise a dry texture adhesive layer, a thermal release layer, or an ultraviolet light release layer. The carrier can comprise electrode layers. The carrier can comprise electrode layers and a dry texture adhesive. It can be the case that an edge of a resulting semiconductor chip does not have a chip or crack that does not have a chip or crack that is larger than 30 µm in a dimension that is a largest dimension.

Besides what is described herein, various modifications can be made to what is disclosed and implementations without departing from their scope. Therefore, the illustrations and examples herein should be construed in an illustrative, and not a restrictive sense.

## Claims

1. A system comprising:
a plasma beam system that is capable of creating trenches in a side of a wafer wherein the trenches define boarders of semiconductor chips housed in the wafer;
a wafer handling unit that is capable of flipping a wafer and placing it on a carrier;
a wafer thinning unit that is capable of thinning a side of a wafer; and
a computing system wherein the computing system comprises instructions for creating trenches in a first side of a wafer wherein the trenches define boarders of semiconductor chips housed in the wafer, flipping a wafer and placing it on a carrier, and for thinning a second side of the wafer.

2. The system of claim 1, wherein the wafer thinning unit is a chemical mechanical polishing unit or an etching unit.

3. The system of claim 1 also including a carrier onto which the wafer can be placed and wherein the carrier comprises a dry texture adhesive layer, a thermal release adhesive layer, or an ultraviolet light release layer.

4. The system of claim 1 also including a carrier onto which the wafer can be placed and wherein the carrier comprises electrode layers.

5. The system of claim 1 also including a carrier onto which the wafer can be placed and wherein the carrier comprises electrode layers and a dry texture adhesive.

6. The system of any of claims 1-5 wherein the plasma beam system is capable of creating trenches that define borders around semiconductor chips of different sizes that are housed in the wafer.

7. A method comprising:
creating trenches in a first side of a wafer wherein the trenches define boarders of semiconductor chips housed in the wafer;
flipping the wafer and placing it on a carrier; and
thinning a second side of the wafer wherein thinning the second side of the wafer causes the wafer to be singulated into semiconductor chips.

8. The method of claim 7 wherein a first set of the semiconductor chips housed in the wafer have different sizes from a second set of the semiconductor chips housed in the wafer.

9. The method of claim 7 wherein the carrier comprises a dry texture adhesive layer, a thermal release layer, or an ultraviolet light release layer.

10. The method of claim 7 wherein the carrier comprises electrode layers and a dry texture adhesive.

11. A computer-readable medium on which instructions are stored in a non-transitory form, that when executed by a computer, cause a system to perform a method of:
creating trenches in a first side of a wafer wherein the trenches define boarders of semiconductor chips housed in the wafer;
flipping the wafer and placing it on a carrier; and
thinning a second side of the wafer wherein thinning the second side of the wafer causes the wafer to be singulated into semiconductor chips.

12. The computer-readable medium of claim 11 wherein a first set of the semiconductor chips housed in the wafer have different sizes from a second set of the semiconductor chips housed in the wafer.

13. The computer-readable medium of claim 11 wherein the carrier comprises a dry texture adhesive layer, a thermal release layer, or an ultraviolet light release layer.

14. The computer-readable medium of any of claims 11-13 wherein an edge of a resulting semiconductor chip does not have a chip or crack that is larger than 30 µm in a dimension that is a largest dimension.

15. The method of any of claims 7-10 wherein an edge of a resulting semiconductor chip does not have a chip or crack that is larger than 30 µm in a dimension that is a largest dimension.
